Europäisches Patentamt

European Patent Office

Office européen des brevets

(11) Publication number: **0 523 279 A1**

# EUROPEAN PATENT APPLICATION

(21) Application number: **91112200.0**

(22) Date of filing: **19.07.91**

(51) Int. Cl.⁵: **H01L 39/22**

(43) Date of publication of application:
**20.01.93 Bulletin 93/03**

(84) Designated Contracting States:
**DE FR GB IT**

(71) Applicant: **International Business Machines Corporation**
**Old Orchard Road**
**Armonk, N.Y. 10504(US)**

(72) Inventor: **Bednorz, Johannes Georg, Dr.**
**Herschärenstrasse**
**CH-8633 Wolfhausen(CH)**
Inventor: **Mannhart, Jochen, Dr.**
**Alte Landstrasse 131**
**CH-8804 Au/ZH(CH)**
Inventor: **Müller, Carl Alexander, Prof. Dr.**
**Haldenstrasse 54**
**CH-8908 Hedingen(CH)**
Inventor: **Schlom, Darrell, Dr.**
**Mythenstrasse 54**
**CH-8800 Thalwil(CH)**

(74) Representative: **Rudack, Günter O., Dipl.-Ing.**
**International Business Machines Corp.,**
**Säumerstrasse 4**
**CH-8803 Rüschlikon(CH)**

(54) **Method for operating electric field-effect devices based on critical current control of their superconducting channel and devices for performing that method.**

(57) Proposed is a method for operating a field-effect device comprised of a superconducting current channel (23) having source and drain electrodes (24, 25) connected thereto, said superconducting current channel (23) being separated from a gate electrode (19) by an insulating layer (22), where the resistance of said current channel (23) is controlled by varying the critical current of the superconducting material through the application of an electrical field across the superconducting current channel (23), which in turn changes the density of the mobile charge carriers in the superconducting material.

Taught is also an inverted MISFET device for performing that method, the device being characterized in that on an electrically conductive substrate (19) an insulating layer (22) is provided which in turn carries a layer (23) consisting of a superconducting material, and that a gate electrode (20) is attached to said substrate (19), and source and drain electrodes (24, 25) are electrically connected to said superconductor layer (23). Advantageously, between the substrate (19) and the superconductive layer (23), a metallic passivation layer (21) may be provided.

FIG. 5

This invention relates to a method for operating field-effect devices having a current channel consisting of superconducting material, where the operation of the devices is controlled through variation of the critical current of the superconductor material. The invention relates also to field-effect devices with which the inventive method can be performed.

Electric field-effect devices, such as field-effect transistors (FET), with semiconducting current channels (between drain and source electrodes) are well known and widely used in many applications. Shortly after the discovery of the high-$T_c$ superconductor materials, Bednorz et al. in their EP-A-0 324 044 predicted on theoretical grounds that high-$T_c$ superconductor materials may bear an electric field-effect which is much larger than that in low-$T_c$ superconductor materials. The length scale by which electrostatic fields are screened in conducting materials is given by the sum $L_D + L_{DZ}$ of the Debye length $L_D = (\epsilon_0\epsilon_r kT/q^2 n)^{1/2}$ and the width of eventual depletion zones $L_{DZ} = N/n$. Here, $\epsilon_0$ and $\epsilon_r$ are the dielectric constants of the vacuum and of the conducting material, respectively, k is Boltzmann's constant, T is the absolute temperature, q is the elementary charge, n is the density of mobile carriers, and N the induced area carrier density. Because of their high carrier density, low-$T_c$ superconductors usually screen electric fields so well that the fields only have a minor influence on materials properties. To attenuate the screening, recent experiments on the electric field-effect in low-$T_c$ superconductors have focused on compounds with exceptionally low carrier density, like doped $SrTiO_3$, with niobium as the dopant, for example (cf. EP-A-91 810 006.6).

As described in EP-A-0 324 044, field-effect devices with superconducting drain-source channels would offer advantages over their semiconducting counterparts. In high-$T_c$ superconductor compounds, larger field-effects can occur owing to their intrinsically low carrier concentration, and because of their small coherence length. The low carrier concentration of about 3... 5 x $10^{21}$/cm$^3$ leads to screening lengths in the range of tenths of nanometers, and the small coherence lengths allow the fabrication of ultrathin layers with respectable critical temperatures. Superconducting films as thin as 1...2 nm have already been grown; electric fields can penetrate such films to a considerable extent. Various types of FETs with superconducting channels have already been suggested, e.g. in EP-A-0 324 044, EP-A- (91 810 006.6), in D.F. Moore, "Superconducting Thin Films for Device Applications", 2$^{nd}$ Workshop on High Temperature Superconducting Electron Devices, June 7-9, 1989, Shikabe, Hokaido, Japan, pp.281-284, and in J. Mannhart et al., "Electric field effect on superconducting $YBa_2Cu_3O_{7-\delta}$ films, Z. Phys. B - Condensed Matter 83, pp. 307-311(1991).

However, all of the prior art devices rely either on an operating temperature close to the critical temperature $T_c$ or on very thin channel layers.

It is an object of the present invention to propose superconducting field-effect devices where the operation is influenced by the control of critical current and flux flow by an electric field.

It is a further object of the invention to teach the operation of superconducting field-effect devices at any temperature from $T = 0$ to $T \simeq T_c$. (It has been observed that the effect is present even at temperatures slightly above $T_c$ ($E = 0$), provided the electrical field acts to increase $T_c$).

It is a still further object to propose superconducting field-effect devices whose conducting channel (between drain and source in case of a FET, for example,) may be grown thicker than permitted in prior art devices.

In acccordance with the invention proposed is a method for operating a field-effect device comprised of a superconducting current channel having source and drain electrodes connected thereto, said superconducting current channel being separated from a gate electrode by an insulating layer, said superconducting current channel being cooled to a temperature close to or below its critical temperature $T_c$, the inventive method being characterized in that the resistance of said current channel is controlled by varying the critical current of the superconducting material forming said current channel through the application of an electrical field across said superconductive current channel, whereby the density of mobile charge carriers in said superconducting material is changed.

Further in accordance with the invention, taught is an inverted MISFET device for performing the inventive method, the device being characterized in that on an electrically conductive substrate an insulating layer is provided which in turn carries a layer consisting of a superconducting material, and that a gate electrode is attached to said substrate, and source and drain electrodes are electrically connected to said superconductor layer.

In the following description a preferred mode of operating a field-effect device in accordance with the invention, and several embodiments of field-effect devices with which the preferred method can be performed will be described by way of example, with reference to the drawings, in which:

Fig. 1     shows the voltage versus current characteristic for a standard superconductor;

Fig. 2     illustrates the effect of an electrical field on the I-V characteristic of a superconductor;

Fig. 3     shows the location of the pinning sites close to the insulator/superconductor interface in a "normal" MISFET device;

Fig. 4 is a cross-section through an "inverted" MISFET (i-MISFET) device having strong- and weak-pinning-force superconducting layers and a normal-conducting buffer layer;

Fig. 5 is a cross-section through an i-MISFET device having a normal-conducting buffer layer;

Fig. 6 is an R(T) diagram showing the influence the variation of the gate voltage has on the resistance of the field-effect device.

Fig. 7 is the measured I-V characteristic of the taught i-MISFET device at a temperature of 4,1 K, showing the influence of the variation of the gate voltage on the critical current of the superconducting channel;

Fig. 8 is the measured I-V characteristic as in Fig. 7 at a temperature of 8,2 K;

Fig. 9 is the measured I-V characteristic as in Fig. 7 at a temperature of 14,6 K;

Fig. 10 is a cross-section through a MISFET in "normal" geometry with a buffer layer.

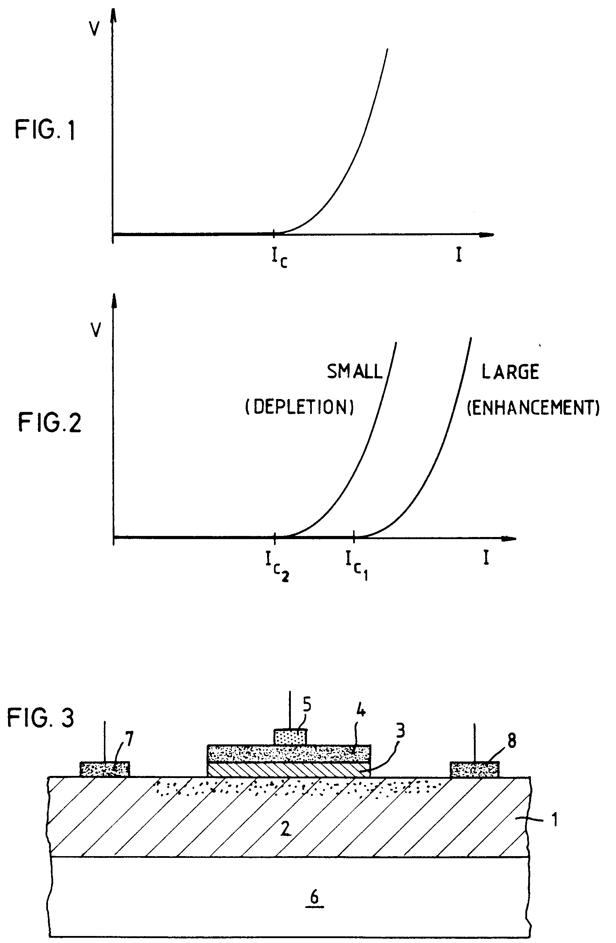

Fig. 1 shows the voltage versus current characteristic for a standard superconductor cooled to a temperature below $T_c$. Up to the critical current $I_c$, an electrical current may flow with negligible resistance through the superconductor. Above $I_c$, the superconductor is resistive because magnetic flux vortices, driven by the Lorentz force $F_L$ of the bias current I move through the superconductor and generate a voltage V. Below the critical current $I_c$, these flux vortices do not move because they are held in place by so-called pinning sites (cf. W. Buckel, "Supraleitung". Verlag Chemie, Weinheim). These pinning sites hold the flux lines with a pinning force $F_P$. The critical current $I_c$ is given by the balance of the pinning force and the Lorentz force: $F_p = F_L$. Above $I_c$, the voltage V generated by the moving flux lines is proportional to both the number of moving flux lines and to their velocity v. The velocity is given by $v \simeq \eta F_p$, $\eta$ being the viscosity factor of flux flow.

The crucial point is that $F_p$ and $\eta$ depend on the density of mobile charge carriers n of the superconductor. In general, a larger n corresponds to a larger $F_p$ and $\eta$. Therefore, the I(V) characteristic of the superconductor depends on n, and if n can be changed by an electrical field E, the I(V) characteristic can be controlled by $\vec{E}$ as illustrated in Fig. 2. Obviously, when a superconducting device is biased with a current I, and $I_{c2} < I < I_{c1}$, the resistance of the superconductor may be switched on and off. In that figure, $I_{c1}$ and $I_{c2}$ are the critical currents associated with large and small numbers n of mobile charge carriers, respectively. In the field-effect device, n is regulated by varying the gate voltage in order to increase ("enhancement" of n) or decrease ("depletion" of n) the number of charge carriers n in the superconducting channel of the device.

It should be pointed out that n has to be changed only near the pinning sites, and not throughout all of the superconductor. This offers the potential advantage to change the critical current $I_c$ of **thick** superconducting films, such as superconductor film 1 in the conventional structure of the metal-insulator-superconductor field-effect transistor (MISFET) device of Fig. 3, with a relatively small electrical field, provided the pinning sites 2 are positioned close to the gate insulator 3 on which a gate electrode 4 is arranged. An electrical field can be applied by supplying a voltage between a gate contact 5 and a source electrode 7. This structure may be arranged on a substrate 6.

The electrical field is screened in the superconductor on a relatively short distance, as described in the above-cited EP-A-0 324 044. But as long as the pinning sites are located in the volume which is penetrated by the electrical field, $I_c$ will be changed even if the remainder of the superconductor is well shielded. For this reason, relatively thick superconducting films may be used as drain-source channels. In the case of $YBa_2Cu_3O_{7-\delta}$ (with $0 < \delta < 1$) the films may have a thickness of about 10 nm. Films of this order of thickness have important advantages, such as ease of fabrication, higher critical temperature $T_c$, and/or better chemical stability.

The principle of the present invention applies to **all** superconductors and may be realized in many configurations. In the following, a preferred embodiment of a heterostructure employing the well-known high $T_c$ superconductor $YBa_2Cu_3O_{7-\delta}$ will be described. Reference is made to the above-cited EP-A-91 810 006.6 and to the concurrently filed EP-A- ("Enhanced Superconducting Field-Effect Transistor with Inverted MISFET Structure and Method for Making the Same", same applicant).

Structures of this type are manufactured from a layer (or substrate) of strontium titanate $SrTiO_3$ onto which a film of $YBa_2Cu_3O_{7-\delta}$ is epitaxially grown. As pinning sites for the $YBa_2Cu_3O_{7-\delta}$ film one may use dislocations or point defects, for example. The density of these pinning sites is a function of the growth conditions of the $YBa_2Cu_3O_{7-\delta}$ film, such as the morphology of the (in casu undoped $SrTiO_3$) substrate surface, growth rate, and growth temperature (cf. EP-A- 91 810 470.4), or stoichiometry. With appropriate adjustment of these parameters, a favorable distribution of the pinning sites may be achieved.

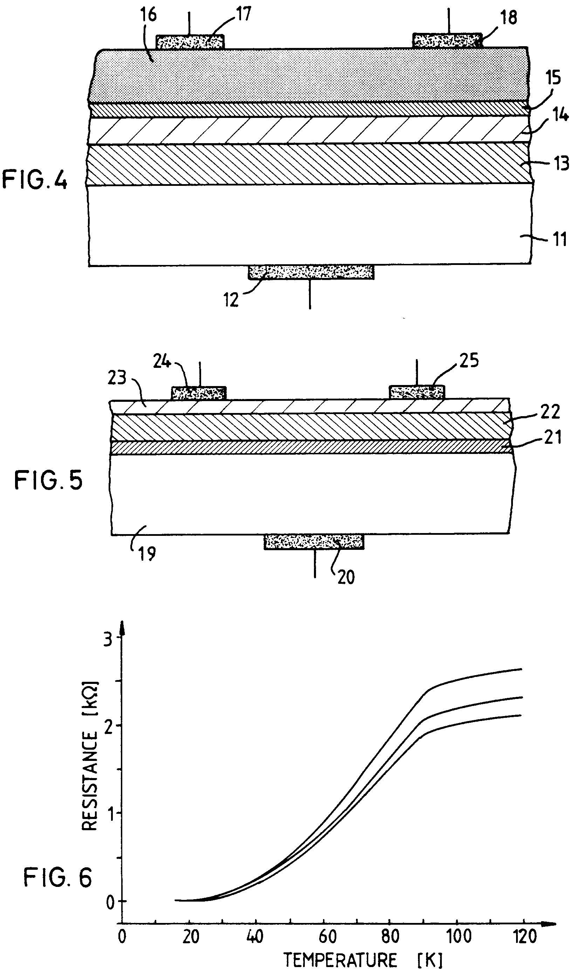

Also, one could take advantage of a multilayer heterostructure as shown in Fig. 4, for example, where films of different superconducting materials and/or of different pinning strengths are employed. A niobium-doped (and therefore conductive) $SrTiO_3$ substrate 11 carries a gate electrode 12 on its lower face while an insulating layer 13 of undoped $SrTiO_3$ is deposited on its upper face.

On top of this insulator layer 13 there is located a thin film 14 of $YBa_2Cu_3O_{7-\delta}$ which has a strong pinning capability. An optional buffer layer 15 consisting, for example, of $PrBa_2Cu_3O_{7-\delta}$ may be provided on top of the superconductor film 14. The uppermost layer 16 of the heterostructure of Fig. 4 is a layer of superconducting $Bi_2Sr_2Ca_2Cu_3O_{10\pm\delta}$ , a material which has a weak pinning capability as compared to the pinning capability of $YBa_2Cu_3O_{7-\delta}$ superconductor layer 14. For electrical contact with superconductor layer 14, on top of the uppermost layer 16 are provided drain and source electrodes 17 and 18, respectively. In view of the fact that said $Bi_2Sr_2Ca_2Cu_3O_{10\pm\delta}$ layer 16, as well as optional $PrBa_2Cu_3O_{7-\delta}$ layer 15 are conductive, there is a low-resistance contact between said drain and source electrodes 17, 18 and superconductor layer 14 in comparison to the resistance the current channel can assume.

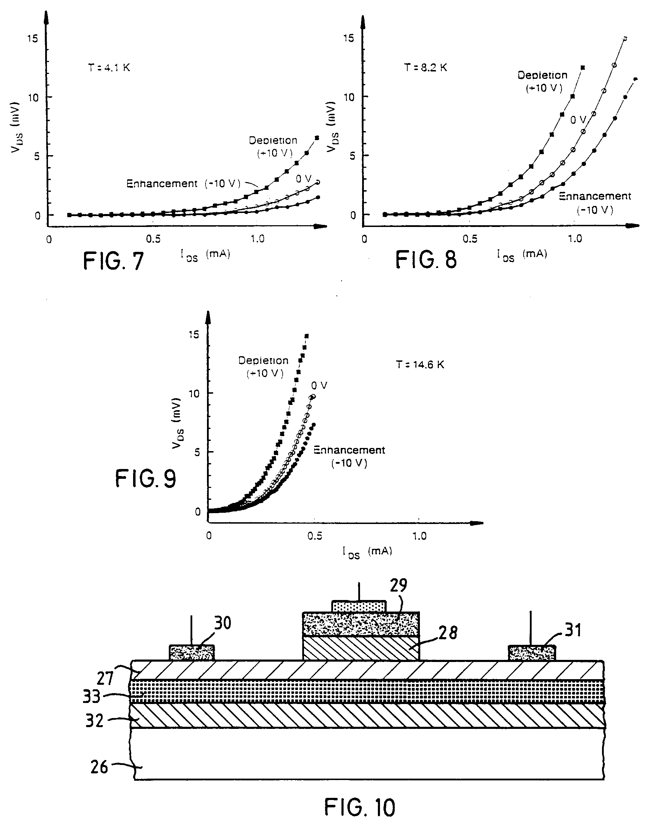

Of course, the structure of Fig. 4 is only one example; it may be varied regarding the materials employed, as concerns the number of pinning sites created in such materials, and with respect to the thickness of the individual layers. A similar multilayer heterostructure may also be fabricated in a "normal" geometry MISFET, such as that shown in Fig. 3, with additional weak pinning superconducting or other conducting layers present beneath layer 1. Such a structure is shown in Fig. 10.

A MISFET device in "normal" geometry would comprise a non-conductive substrate 26, a first layer 27 consisting of a superconducting material having a first pinning force and overlaying said substrate 26, an insulating layer 28 placed on top of said first superconductor layer 27. The insulating layer 28 is in turn overlaid by a gate electrode 29, and source and drain electrodes 30 and 31 are electrically connected to said first superconductor layer 27. Between said first superconductor layer 27 and said substrate 26 a second superconductor layer 32 having a second pinning force weaker than the pinning force of the first superconductor layer 27 is arranged. Optionally, between the first and second superconductor layers 27 and 32 a conducting buffer layer 33 may be provided.

In a preferred embodiment of the invention, said second, relatively weaker pinning force superconductor layer 32 consisted of $Bi_2Sr_2Ca_2Cu_3O_{10\pm\delta}$ , and the conducting buffer layer 33 consisted of $PrBa_2Cu_3O_{7-\delta}$ , where $0 < \delta < 1$ .

In an experiment to demonstrate the effect of electrical fields on pinning and, thus, control of the critical current of a superconducting channel, a heterostructure (inverted metal-insulator-superconductor field-effect transistor (i-MISFET) was grown in accordance with the teaching of the above-cited EP-A- ("Enhanced Superconducting Field-Effect Transistor with Inverted MISFET Structure and Method for Making the Same", same applicant, concurrently filed). Fig. 5 shows the structure of this i-MISFET.

The gate 19 of the i-MISFET consisted of a conducting n-type (0.05% Nb-doped) $SrTiO_3$ (100) single crystal substrate grown by the floating-zone technique, an Ag contact 20 was fixed to it diffusing Ag into the $Nb:SrTiO_3$ substrate. This substrate 19 was heated to $\approx 600°C$ and a thin (i.e. 2 - 5 nm) epitaxial passivation layer 21 of platinum was deposited onto its upper surface by electron-beam evaporation. At a substrate temperature $T_{sub}$ of $\approx 680°C$, a (100) oriented layer 22 of undoped $SrTiO_3$, $\approx 500$ nm thick, was deposited by radio frequency (RF) magnetron sputtering in a 6,7 Pa argon-oxygen ambient ($Ar:O_2 = 2:1$).

Without leaving the vacuum environment, a layer 23 of $YBa_2Cu_3O_{7-\delta}$ , between 4 and 10 nm thick was then deposited by DC magnetron sputtering at $T_{sub} \approx 750°C$ and a pressure of about 90 Pa ($Ar:O_2 = 2:1$). The structure was then cooled in $\approx 50$ kPa $O_2$. Using conventional photolithography and wet etching (in dilute $H_3PO_4$), the structure was patterned, and gold contact pads 24 and 25 were made to form source and drain electrodes, respectively. The structures prepared in accordance with the method just described had a gate resistivity of $10^{12} - 10^{13}$ $\Omega$cm at 10 V in both polarities, increasing rapidly with decreasing gate voltage.

It was found that without the presence of a platinum layer 21, the surface region of the normally conducting $Nb:SrTiO_3$ substrate 19 was degraded and insulating, resulting in a dramatic lowering of the capacitance $C_{GS}$ between gate 20 and source 24 of the i-MISFET structure. This degraded the performance of the device so that only a few percent resistivity modulation was observed. With the platinum layer 21, however, $C_{GS}$ was greatly improved (roughly three-fold) and more than an order of magnitude improvement in resistivity modulation was observed.

It is worth noting that in addition to the beneficial effect of Pt layer 21 diffusing into the dead surface layer of the Nb-doped gate substrate 19, Pt diffusion through the undoped $SrTiO_3$ layer 22 into the $YBa_2Cu_3O_{7-\delta}$ superconducting channel layer 23 did occur for the processing conditions used. This resulted in a broadening of the superconducting transition. For this reason, best results were achieved with relatively thin Pt layers 21 and comparatively thick $SrTiO_3$ layers 22. By lowering the processing temperatures after the deposition of the Pt layer 21, further improvements in device performance may be expected.

Platinum was found to be beneficial for improving the properties of the dead layer at the surface of the $Nb:SrTiO_3$ substrates for several reasons: It is highly conductive, it is resistant to oxidation (namely to the oxidizing conditions during the deposition of the undoped $SrTiO_3$ and $YBa_2Cu_3O_{7-\delta}$ films), its lattice constant and its coefficient of thermal expansion are close to those of $SrTiO_3$ and $YBa_2Cu_3O_{7-\delta}$. Besides satisfying these issues of structural compatibility, platinum is reasonably chemically compatible, i.e. it does not significantly react with, or impair the properties of the insulating and superconducting layers, respectively.

Besides platinum, there are other materials that satisfy many of these constraints and that may be useful for this application. Examples are rhodium, palladium, silver, gold, and their alloys. In particular, the lattice constant of Pt-Rh alloys can be varied between 0,3804 nm (for pure Rh) and 0,3924 nm (for pure Pt) by controlling the composition of the alloy during deposition. This ability allows for an even better lattice match to the surrounding layers to be obtained. The appropriate alloy composition yielding (roughly) the desired lattice constant can be calculated with Vegard's law, as follows:

For two components of an alloy, A and B, having the same crystal structure, and for which a substitutional solid solution exists, the lattice constant $a_{mix}$ of a mixture containing X atomic % of A and (1-x) atomic % of B is approximately given by:

$$a_{mix} \simeq x^{\bullet} a_A + (1 - x)a_B$$

where $a_A$ and $a_B$ are respectively the lattice constants of pure A and pure B.

In the structure manufactured as described above, the $YBa_2Cu_3O_{7-\delta}$ film 15 became superconducting at about 14 K as shown in Fig. 6. Fig. 7, 8 and 9 show three drain-source voltage-versus-current characteristics measured at 4.1 K, 8,2 K, and 14,6 K, with the gate voltage as a parameter. Applying a positive bias voltage between the gate and source contacts ($V_{GS} > 0$) decreases (depletion) the carrier concentration in the channel of the p-type superconductor, whereas applying a negative bias voltage ($V_{GS} < 0$) increases (enhancement) the carrier concentration in the channel. Figs. 7, 8, and 9 show that a gate voltage change of ±10 V causes a variation of the critical current leading to a shift in the $V_{DS}(I_{DS})$ characteristic of about ±200 $\mu A$.

It is pointed out that for $YBa_2Cu_3O_{7-\delta}$ films, the I(V) curves below $T_c$ are usually smooth, and do not display any well-defined feature suited for determining the critical current density; cf. Figs. 1 and 3 of J.S. Satchell et al., "Electrical Properties of $YBa_2Cu_3O_7$ Thin Films", Physica C. 162-164 (1989) p. 625. This problem makes it difficult to provide an accurate number for the field-induced change of the critical current, but this is believed to be within the ±100 to ±200 $\mu A$ range. While the measurements that lead to Figs. 7, 8, and 9 were made with a gate voltage of ±10 V, it will be clear to those skilled in the art that operation of the taught structure is possible generally with gate voltages in the range between 1 and 100 V.

## Claims

1. Method for operating a field-effect device comprised of a superconducting current channel (1, 14, 23) having source and drain electrodes (7, 8; 17, 18; 24, 25) connected thereto, said superconducting current channel (1, 14, 23) being separated from a gate electrode (4, 12, 19) by an insulating layer (3, 13, 22), said superconducting current channel (1, 14, 23) being cooled to a temperature close to or below its critical temperature $T_c$, **characterized** in that the resistance of said current channel (1. 14, 23) is controlled by varying the critical current ($I_c$) of the superconducting material forming said superconducting current channel (1, 14, 23) through the application of an electrical field ($\vec{E}$) across said superconducting current channel (1, 14, 23), whereby the density of mobile charge carriers (n) in said superconducting material is changed.

2. Method for operating a field-effect device in accordance with claim 1, **characterized** in that said density of mobile charge carriers (n) in said superconducting material is changed only near the strongest pinning sites (2) thereof.

3. Method for operating a field-effect device in accordance with claim 1, **characterized** in that a bias current (I) is passed through said superconductive current channel (1, 14, 23), that with said bias current (I) exceeding said critical current ($I_c$), said superconducting material is in its resistive state, with the flux vortices moving through the superconductor and generating a potential difference over said drain and source electrodes (7, 8; 17, 18; 24, 25), and that with said bias current (I) being smaller than the critical current ($I_c$), said superconductive material is in its superconductive state with the pinning sites (2) in said material holding the magnetic flux vortices in place, and a negligibly small potential difference only being generated over said drain and source electrodes (7, 8; 17, 18; 24, 25).

4. Method for operating a field-effect device in accordance with claim 1, *characterized* in that the critical current ($I_c$) of said superconductor material is controlled by a gate voltage (V) applied between said source/drain electrode (7. 8; 17, 18; 24, 25) on the one hand, and said gate electrode (4, 12,19) on the other hand.

5. Method for operating a field-effect device in accordance with claim 4, *characterized* in that a gate voltage (V) of either positive or negative polarity is applied to the gate electrode.

6. Method for operating a field-effect device in accordance with claim 4, *characterized* in that said gate voltage (V) is in the range between 1 and 100 V.

7. Method for operating a field-effect device in accordance with claim 1, *characterized* in that in the case of the bias current (I) exceeding said critical current ($I_c$), the potential difference generated between said drain and source electrodes (7, 8; 17, 18; 24, 25) is proportional to the number of moving flux lines and to their velocity (v), the latter being approximated by the product of the Lorentz force ($F_L$) and the viscosity factor ($\eta$) for flux flow.

8. Inverted MISFET device for performing the method in accordance with claim 1, *characterized* in that on an electrically conductive substrate (6,11, 19) an insulating layer (3, 13, 22) is provided which in turn carries a layer (1, 14, 23) consisting of a superconducting material, that a gate electrode (4, 12, 20) is attached to said substrate (6, 11, 19), and that source and drain electrodes (7, 8; 17, 18; 24, 25) are electrically connected to said superconductor layer (1, 14, 23).

9. Inverted MISFET device in accordance with claim 8, *characterized* in that said substrate (6, 11, 19) consists of niobium-doped strontium titanate (Nb:SrTiO$_3$) and that said superconductor layer (1, 14, 23) consists of YBa$_2$Cu$_3$O$_{7-\delta}$, where $0 < \delta < 1$.

10. Inverted MISFET device in accordance with claim 8, *characterized* in that between said substrate (19) and said insulating layer (22) a passivation layer (21) consisting of a metal selected from the group comprising platinum, rhodium, palladium, silver, gold and their alloys, is provided.

11. Inverted MISFET device in accordance with claim 8, *characterized* in that on top of said superconductor layer (14) a superconducting layer (16) having a weaker pinning force than the said superconductor layer (14) is arranged, and that said source and drain electrodes (17, 18) are attached to said weak pinning force superconducting layer (16).

12. Inverted MISFET device in accordance with claim 11, *characterized* in that between said superconductor layer (13) and said weak pinning force superconductor layer (16) a conducting buffer layer (15) is provided.

13. Inverted MISFET device in accordance with claim 12, *characterized* in that said weak pinning force superconductor layer (16) consists of Bi$_2$Sr$_2$Ca$_2$Cu$_3$O$_{10\pm\delta}$, and that said conducting buffer layer (15) consists of PrBa$_2$Cu$_3$O$_{7-\delta}$, where $0 < \delta < 1$.

14. MISFET device for performing the method in accordance with claim 1, comprising a non-conductive substrate (26), a a first layer (27) consisting of a superconducting material having a first pinning force and overlaying said substrate (26), an insulating layer (28) placed on top of said first superconductor layer (27), in turn overlaid by a gate electrode (29), and source and drain electrodes (30, 31) electrically connected to said first superconductor layer (27), *characterized* in that between said first superconductor layer (27) and said substrate (26) a second superconductor layer (32) having a second pinning force weaker than said first pinning force of said first superconductor material is arranged.

15. MISFET device in accordance with claim 14, *characterized* in that between said first and second superconductor layers (27, 32) a conducting buffer layer (33 ) is provided.

16. Inverted MISFET device in accordance with claim 14, *characterized* in that said first relatively strong pinning force superconductor layer (26) consists of YBa$_2$Cu$_3$O$_{7-\delta}$, that said second, relatively weaker pinning force superconductor layer (32) consists of Bi$_2$Sr$_2$Ca$_2$Cu$_3$O$_{10\pm\delta}$, and that said conducting buffer layer (33) consists of PrBa$_2$Cu$_3$O$_{7-\delta}$, where $0 < \delta < 1$.

FIG. 1

FIG. 2

SMALL
(DEPLETION)

LARGE
(ENHANCEMENT)

FIG. 3

FIG.4

FIG.5

FIG.6

FIG. 7

FIG. 8

FIG. 9

FIG. 10

European Patent
Office

EUROPEAN SEARCH REPORT

Application Number

EP    91 11 2200
Page 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 354 804 (THE FURUKAWA ELECTRIC CO.,LTD.) <br> * column 3, line 35 - column 4, line 20 * <br> * column 5, line 1 - line 26 * <br> * column 5, line 46 - column 6, line 5 * <br> * column 6, line 65 - column 8, line 8 * <br> * claims 1-2; figures 1,3 * | 1-5,8 | H01L39/22 |
| X | IEEE TRANSACTIONS ON MAGNETICS <br> vol. 23, no. 2, March 1987, NEW YORK, US <br> pages 1279 - 1282; <br> HEBARD A.S. ET AL.: 'Experimental Considerations in the Quest for a Thin-Film Superconducting Field-Effect Transistor' <br> * page 1279, paragraph 3 -paragraph 6; figure 1 * <br> * page 1281, paragraph 1 -paragraph 3 * <br> * page 1282, paragraph 3; figure 5 * | 1,4 | |
| D,X | EP-A-0 324 044 (IBM) <br> * page 3, line 33 - page 4, line 6 * <br> * page 4, line 25 - page 5, line 37; claims 1-10; figures 1-3 * | 1,4-5,8 | TECHNICAL FIELDS SEARCHED (Int. Cl.5) |
| D,X | WORKSHOP ON HIGH TEMPERATURE SUPERCONDUCTING ELECTRON DEVICES <br> 7 June 1989, SHIKABE, JAPAN <br> pages 281 - 284; <br> D.F.MOORE ET AL: 'Superconducting Thin Films for Device Applications' <br> * page 281, paragraph 3 * <br> * page 282, paragraph 4 -paragraph 6 * <br> * page 283; figures 1-3 * | 1,4-5,8 | H01L |

-/--

The present search report has been drawn up for all claims

| Place of search | Date of completion of the search | Examiner |
|---|---|---|
| THE HAGUE | 28 FEBRUARY 1992 | HAMMEL E.J. |

EPO FORM 1503 03.82 (P0401)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | APPLIED PHYSICS LETTERS<br>vol. 55, no. 19, 6 November 1989, NEW YORK, US<br>pages 2032 - 2034;<br>ROGERS C.T. ET AL: 'Fabrication of heteroepitaxial YBa2Cu3O7-x-PrBa2Cu3O7-x-YBa2-Cu3O7-x Josephson devices grown by laser deposition'<br>* page 2032, paragraph 2 -paragraph 5; figure 1 * <br><br>--- | 11-16 | |
| A | PATENT ABSTRACTS OF JAPAN<br>vol. 12, no. 423 (E-680)9 November 1988<br>& JP-A-63 160 273 ( FUJITSU )<br>* abstract *<br><br>----- | 1-4,<br>10-13,<br>15-16 | |
| | | | TECHNICAL FIELDS SEARCHED (Int. Cl.5) |

The present search report has been drawn up for all claims

| Place of search | Date of completion of the search | Examiner |
|---|---|---|
| THE HAGUE | 28 FEBRUARY 1992 | HAMMEL E.J. |

EPO FORM 1503 03.82 (P0401)